# EUROPÄISCHE PATENTSCHRIFT

(11) **EP 0 272 514 B1**
(45) Veröffentlichungstag und Bekanntmachung des Hinweises auf die Patenterteilung: **10.11.1993**
(21) Anmeldenummer: 87117919.8
(22) Anmeldetag: 03.12.1987
(51) Int. Cl.: H02H 9/00

(54) **Schaltungsanordnung zur Einschaltstrombegrenzung und zum Überspannungsschutz bei getakteten Stromversorgungsgeräten**
Circuit arrangement for limiting the switch-on current and for overvoltage protection of switched power supply apparatuses
Circuit de limitation du courant de démarrage et de protection contre des surtensions pour des alimentations de courant commutées

(30) Priorität: 23.12.1986 DE 3644321
(43) Veröffentlichungstag der Anmeldung: 29.06.1988
(73) Patentinhaber: SIEMENS AKTIENGESELLSCHAFT, 80333 München (DE)
(72) Erfinder: Preis, Josef, Dipl.-Ing., D-8000 München 60 (DE); Schwarz, Ulf, Dipl.-Ing., D-8023 Pullach (DE); Stolz, Gerhard, Dipl.-Ing., D-8034 Germering (DE)

(56) Entgegenhaltungen:
- DE-A- 2 143 908
- DE-A- 3 535 864
- US-A- 3 935 527
- ELECTRONICS INTERNATIONAL, Band 56, Nr. 23, 17. November 1983, Seite 133, New York, US; J.E. BUCHANAN: "Limiting a filter capacitors turn-on in rush current"
- EDN ELECTRICAL DESIGN NEWS, Band 30, Nr. 20, September 1985, Seiten 141-146, Newton, US; N. SOKAL: "Circuits eliminate power-supply surge currents"

## Beschreibung

Die Erfindung bezieht sich auf eine wie im Oberbegriff des Patentanspruchs 1 angegebene Schaltungsanordnung zur Verringerung des Einschaltstroms bei getakteten Stromversorgungsgeräten.

Die Anmelderin hat sich unter Bezugnahme auf die DE 35 35 864 A1 freiwillig eingeschränkt und gesonderte Patentansprüche für die Bundesrepublik Deutschland vorgelegt.

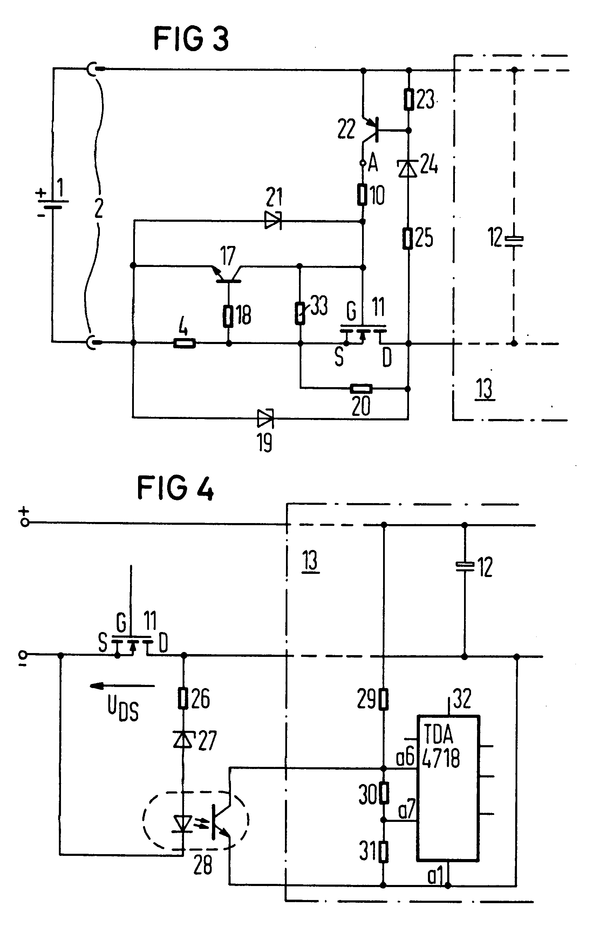

Eine wie im Oberbegriff des Patentanspruchs 1 angegebene Schaltungsanordnung ist bereits aus der Zeitschrift E.D.N. Electrical Design News 30 (1985), September, No. 20, Newton, Massachusetts, USA, Seite 143, Figur 3 bekannt. Die bekannte Schaltungsanordnung enthält als Verzögerungsglied eine aus einem Widerstand und einem Kondensator bestehende Serienschaltung, die an eine Speisespannungsquelle angeschlossen ist. Im Längszweig der Schaltungsanordnung ist die Drain-Source-Strecke eines Feldeffekttransistors angeordnet. Durch den Feldeffekttransistor fließt erst dann ein Ladestrom in den nachfolgenden Speicherkondensator, wenn der Kondensator des Verzögerungsgliedes auf eine ausreichend große Spannung aufgeladen ist. Dieser Ladestrom ist zunächst vorübergehend dadurch begrenzt, daß der Feldeffekttransistor beim Übergang vom gesperrten in den gesättigten Zustand einen endlichen Widerstand darstellt. Ist der Feldeffekttransistor gesättigt, so ist der maximal fließende Ladestrom praktisch nur durch die vergleichsweise niedrigen Innen- bzw. Verlustwiderstände der Schaltungsanordnung begrenzt. Tritt in diesem Betriebszustand am Eingang der Schaltungsanordnung ein Überspannungsimpuls auf, so gelangt dieser über den gesättigten Feldeffekttransistor praktisch ungehindert zum Speicherkondensator.

Getaktete Stromversorgungsanordnungen enthalten im allgemeinen im Eingangskreis eine vergleichsweise große Kapazität, üblicherweise gebildet durch einen Elektrolytkondensator. Diese Kapazität dient als niederohmige Quelle für die primärseitigen Pulsströme der Umrichterschaltung und ist, zusammen mit der ihr vorgeschalteten Induktivität eines Rückwirkungssiebes im wesentlichen für die Höhe und Form des Einschaltstromes verantwortlich.

Der Ladestrom, der beim Stecken oder Einschalten des betreffenden Stromversorgungsgerätes in den Speicherkondensator fließt, kann vorgeschaltete Sicherungen zum Auslösen bringen und bei steckbaren Stromversorgungsgeräten die Steckerstifte zerstören, sofern das als Einschub, Einsatz oder steckbare Baugruppe ausgebildete Gerät unter Spannung gesteckt wird.

Weiterhin ist es üblich, Stromversorgungsgeräte der eingangs genannten Art einer Prüfung zu unterziehen, bei der das Stromversorgungsgerät an seinem Eingang mit Spannungsimpulsen bestimmter Form und Höhe beaufschlagt wird. Diese Impulse können empfindliche Bauteile wie z.B. Halbleiter zerstören.

Aufgabe der Erfindung ist es, eine wie im Oberbegriff des Patentanspruchs 1 angegebene Schaltungsanordnung derart auszubilden, daß sowohl der Einschaltstrom begrenzt als auch ein Schutz gegen Überspannungen am Speicherkondensator gewährleistet wird.

Man kann zu diesem Zweck einen in Bezug auf den Einschaltstrom entsprechend großen Sicherungsautomaten auswählen und als Schutz gegen Überspannungen eine Z-Diode verwenden, die jedoch eine mit der Höhe des Spannungspulses überproportional steigende Energie aufnehmen muß und daher unter Umständen selbst gefährdet ist.

Überlegungen im Rahmen der Erfindung haben ergeben, daß es zur Lösung der gestellten Aufgabe zweckmäßig ist, dem Speicherkondensator ein Stellglied vorzuschalten und
a) im Moment des Steckens oder Einschaltens des Stromversorgungsgerätes den Eingangsstrom entweder auf Null oder einen wählbaren, für die Lebensdauer der Steckkontakte oder Schalter bei vergleichsweise häufigem Stecken oder Schalten ausreichend niedrigen Wert zu begrenzen,
b) nach einer wählbaren Zeit den Eingangsstrom auf einen höheren Wert zu begrenzen, der einerseits für den Start der Stromversorgungsanordnung ausreichend groß und andererseits im Hinblick auf vorgegebene Einschaltstromforderungen noch zulässig ist. Dieser Wert soll gegebenenfalls so liegen, daß die zulässige Stecker-Kontaktbelastung im gesteckten Zustand nicht überschritten wird,
c) nach erfolgtem Start der Stromversorgung das Stellglied so durchzusteuern, daß daran nur möglichst niedrige Verluste entstehen,
d) beim Eintreffen eines Überspannungsimpulses und der hierdurch verursachten Stromerhöhung die unter b) beschriebene Strombegrenzung wieder wirksam werden zu lassen, wodurch die kurzzeitige eingangsseitige Spannungserhöhung sich wegen der Eingangskapazität nur unwesentlich am Eingang der nachfolgenden Stromversorgungsanordnung auswirken kann.

Gemäß der Erfindung wird das Stromversorgungsgerät in der im kennzeichnenden Teil des Patentanspruchs 1 angegebenen Weise ausgebildet. Dabei ist der Speicherkondensator über einen Schalter und/oder Stecker mit der Speisespannungsquelle verbindbar. Die Source-Drain-Strecke des Feldeffekttransistors und der Strommeßwiderstand können in gleichen oder verschiedenen Zweigen des Speisekreises liegen.

Durch diese Maßnahmen ergibt sich der Vorteil, daß mit Hilfe ein und desselben Stellgliedes zugleich ein zeitlich gestufter Schutz gegen Überströme und ein wirksamer Schutz gegen Überspannungen erreicht wird. Dabei steht die Vorrichtung zur Strombegrenzung in direktem Eingriff auf das Gate des Feldeffekttransistors und begrenzt den Strom auf den festgelegten Wert und dies unverzögert und unabhängig von der Kapazität und vom jeweiligen Ladezustand des im Verzögerungsglied enthaltenen Kondensators.

Aus der DE-OS 21 43 908 ist zwar eine Schaltungsanordnung mit Strombegrenzung bekannt, die im Längszweig die Emitter-Kollektorstrecke eines bipolaren Transistors enthält. Dieser Transistor ist Bestandteil einer Anordnung zur Spannungsstabilisierung und zur Strombegrenzung. Außerdem weist die Schaltungsanordnung am Eingang eine an Versorgungsspannung schaltbares RC-Schaltung auf, dessen Kondensatorspannung unmittelbar den genannten bipolaren Transistor steuert. Die Anordnung zur Strombegrenzung bestimmt die Größe des Stromes, der beim Einschalten fließt. Die Kondensatorspannung sorgt für eine Reduktion des Kurzschlußstromes nach einer vorgegebenen Zeit.

Vorteilhafte Ausgestaltungen der Erfindung ergeben sich aus den Unteransprüchen.

Bei der Ausbildung nach Anspruch 2 (bzw. Anspruch 6 der Fassung für DE) ist der Verstärker an eine externe Referenzspannungsquelle angeschlossen. Bei der Weiterbildung nach Anspruch 3 (bzw. Anspruch 7 der Fassung für DE) ist in vorteilhafter Weise eine externe Referenzspannungsquelle nicht erforderlich.

Bei der Weiterbildung der Erfindung nach Anspruch 4 in der Fassung für alle Vertragsstaaten außer DE ist das Verzögerungsglied so ausgebildet, daß es vor Ablauf der Verzögerungszeit ein den Feldeffekttransistor sperrendes Potential abgibt. Bei der Weiterbildung nach Anspruch 6 ist vor Ablauf der Verzögerungszeit das leitend steuernde Potential abgeschaltet. Die Sperrung des Feldeffekttransistors ergibt sich in diesem Fall durch das Fehlen des leitend steuernden Potentials in Verbindung mit dem zwischen Gate und Source wirksamen Widerstand.

Durch die Maßnahmen nach Anspruch 9 ergibt sich in vorteilhafter Weise ein Schutz der Schaltungsanordnung bei inversen Strömen im Ladekreis des Speicherkondensators.

Die Erfindung wird anhand der in den Figuren dargestellten Ausführungsbeispiele näher erläutert.

Die Figuren 1 bis 3 zeigen jeweils eine Schaltungsanordnung zur Einschaltstrombegrenzung und zum Überspannungsschutz bei einem getakteten Stromversorgungsgerät, bei dem im Ladestromkreis eines Speicherkondensators ein als Stellglied dienender Feldeffekttransistor angeordnet ist, und zwar
- Figur 1: eine Schaltungsanordnung mit einem Differenzverstärker als Verstärker für die Strombegrenzung und mit einem RC-Glied als Verzögerungsglied,
- Figur 2: eine Schaltungsanordnung, bei der ein bipolarer Transistor zugleich als Referenzspannungsgeber und Komparator zur Strombegrenzung dient und
- Figur 3: eine Schaltungsanordnung, bei der der Speicherkondensator Bestandteil eines Verzögerungsgliedes ist.
- Figur 4: zeigt für die Schaltungsanordnungen nach Figuren 1 - 3 eine Anordnung, bei der ein als Stellglied vorgesehener Feldeffekttransistor zugleich als Steuerspannungsgeber zum Ein-/Ausschalten der Stromversorgungsanordnung dient.

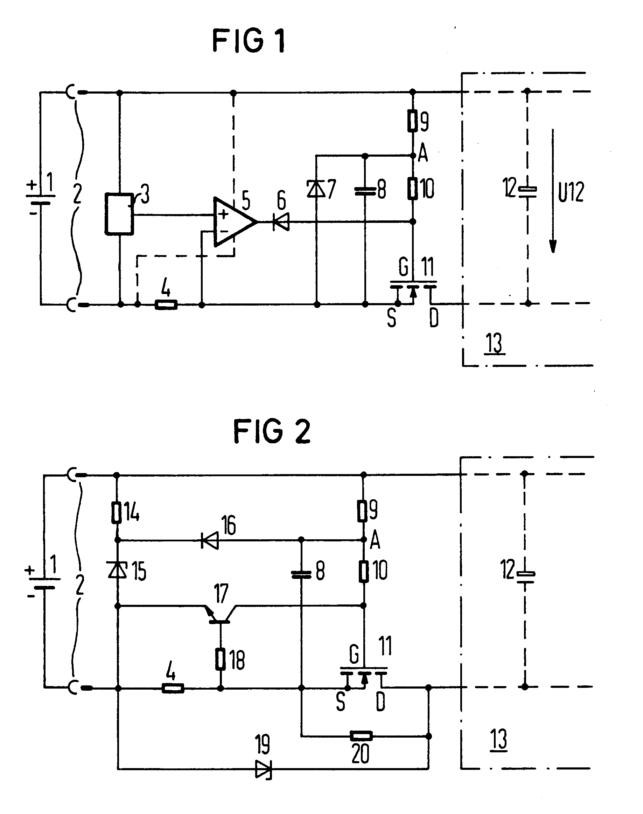

Die in Figur 1 gezeigte Schaltungsanordnung zur Einschaltstrombegrenzung und zum Überspannungsschutz ist zwischen einem Versorgungsnetz bzw. der Versorgungsspannungsquelle 1 und dem Speicherkondensator 12 der Stromversorgungsanordnung 13 angeordnet. Die Schaltungsanordnung zur Einschaltstrombegrenzung und zum Überspannungsschutz ist zusammen mit der zu schützenden Stromversorgungsanordnung in ein und demselben Gerät untergebracht und über die Kontakte 2 eines in der Figur nicht näher dargestellten Vielfachsteckverbinders mit der Versorgungsspannungsquelle 1 verbindbar. Der Speicherkondensator 12 ist auf der einen Seite über einen Steckkontakt mit dem Pluspol der Versorgungsspannungsquelle 1 verbunden und auf der anderen Seite über die Drain-Source-Strecke des als Leitungs-MOS-FET ausgebildeten Feldeffekttransistors 11, den dazu in Serie liegenden als Istwertgeber dienenden Strommeßwiderstand 4 und einen weiteren Kontakt des Vielfachsteckverbinders mit dem Minuspol der Versorgungsspannungsquelle 1 verbunden.

Das Gate G des als Stellglied dienenden Feldeffekttransistors 11 ist einerseits über die Diode 6 mit dem Ausgang des Verstärkerelementes 5 und andererseits über den Widerstand 10 mit dem Ausgang A eines aus dem Widerstand 9 und dem Kondensator 8 bestehenden RC-Gliedes verbunden. Die Serienschaltung von Kondensator 8 und Widerstand 9 ist an die Versorgungsspannungsquelle 1 angeschlossen. Der Verbindungspunkt von Kondensator 8 und Widerstand 9 bildet den Ausgang A des Verzögerungsgliedes. Parallel zum Kondensator 8 liegt die Z-Diode 7. Die Z-Diode 7 ist so gepolt, daß sie die am Kondensator 8 auftretende Spannung auf den Wert ihrer Zenerspannung begrenzt.

Das zum Soll-Istwert-Vergleich dienende Verstärkerelement 5 ist durch einen Differenzverstärker gebildet, dessen nicht invertierender Eingang + an den Sollwertgeber 3 und dessen invertierender Eingang - an den Verbindungspunkt von Strommeßwiderstand 4 und Source des Feldeffekttransistors 11 verbunden ist. Der Sollwertgeber 3 und das Verstärkerelement 5 werden - gegebenenfalls über geeignete Versorgungseinrichtungen - aus der Versorgungsspannungsquelle 1 mit Betriebsspannung versorgt. Die Diode 6 ist so gepolt, daß sie für Pluspotential am Ausgang des Differenzverstärkers 5 gesperrt und bei Minuspotential am Ausgang des Differenzverstärkers 5 leitend ist. Die Diode 6 kann entfallen, wenn der Differenzverstärker 5 einen offenen Kollektorausgang aufweist, so daß zusätzliche Entkopplungsmaßnahmen an seinem Ausgang nicht erforderlich sind.

Legt man Spannung an den durch die Kontakte 2 gebildeten Eingang der Schaltungsanordnung, so fließt zunächst wegen des noch entladenen Kondensators 8 noch kein Ladestrom in den Kondensator 12. Dabei gibt der Verstärker 5 am Ausgang eine positive Spannung ab, die jedoch wegen der als Entkopplungsdiode dienenden Diode 6 am Gate G des Feldeffekttransistors bzw. MOS-FET 11 nicht wirksam werden kann.

Der Kondensator 8 wird gleichzeitig über den als Ladewiderstand dienenden Widerstand 9 langsam geladen. Sobald nach einer durch die Ladezeitkonstante festgelegten Verzögerungszeit die Spannung am Kondensator 8 und damit die Gatespannung des MOS-FET 11 auf die Schwellenspannung des MOS-FET 11 von etwa 3 V angestiegen ist, beginnt dieser niederohmig zu werden und läßt Strom in die angeschlossene Stromversorgungsanordnung 13 fließen.

Erreicht dieser Strom eine Höhe, bei der sein Spannungsabfall am Strommeßwiderstand 4 die vom Referenzspannungsgeber 3 abgegebene Referenzspannung erreicht, geht die Ausgangsspannung des Verstärkers 5 gegen Minuspotential und begrenzt durch den direkten Eingriff auf das Gate des MOS-FET 11 den Strom auf den so festgelegten Wert. Bedingt durch den Widerstand 10, der zwischen dem Kondensator 8 und der Entkopplungsdiode 6 liegt, kann dieser Eingriff unabhängig von der Spannung am Kondensator 8 erfolgen. Sobald der Eingangskondensator 12 der Stromversorgungsanordnung 13 geladen und diese in Betrieb ist, sinkt der Strom auf deren statischen Eingangsstrom, der Verstärker 5 wird an seinem Ausgang wieder positiv und der Kondensator 8 kann über den Ladewiderstand 9 nun vollständig bis zu der durch die Z-Diode 7 festgelegten Spannung aufgeladen werden. Liegt diese Spannung ausreichend hoch, z.B. bei etwa 10 V, so ist der MOS-FET 11 niederohmig und damit ein verlustarmer Betrieb gewährleistet.

Beim Eintreffen eines Überspannungsimpulses sei die angeschlossene Stromversorgungsanordnung in Betrieb, der Kondensator 8 auf die Begrenzungsspannung aufgeladen, der Verstärker 5 positiv übersteuert und am Ausgang stromlos und damit der MOS-FET 11 niederohmig. Durch den schnellen Spannungsanstieg am Eingang der Schaltungsanordnung bzw. an den Kontakten 2 steigt - bedingt durch die Eingangskapazität der Stromversorgungsanordnung - der Eingangsstrom schnell an, wird jedoch ebenso wie beim Einschalten durch Vergleichsschaltung, Verstärker 5, Entkopplungsdiode 6 und MOS-FET 11 auf den festgelegten Wert begrenzt, wobei der Widerstand 10 einen unverzögerten Eingriff des Verstärkers 5 ermöglicht.

Durch die strombegrenzende Wirkung der Schaltungsanordnung führen die in Versorgungsnetzen vorkommenden hohen aber kurzen Überspannungen nur zu einem geringen Anstieg U12 der Spannung am Eingang der Stromversorgungsanordnung 13. Die Spannungsdifferenz liegt am MOS-FET 11 der Schutzschaltung, der für diese Spannung zu bemessen ist. Nach Ende der Überspannung kehrt die Schaltungsanordnung wieder in den Normalzustand mit voll durchgesteuertem MOS-FET 11 zurück.

Die in Figur 2 gezeigte Schaltungsanordnung stimmt mit der nach Figur 1 weitgehend überein. Abweichend von Figur 1 ist als Verstärker der bipolare Transistor 17 vorgesehen, dessen Emitter an den Minuspol der Versorgungsspannungsquelle 1, dessen Kollektor an die Steuerelektrode des Feldeffekttransistors 11 und dessen Basis über den Widerstand 18 an den Verbindungspunkt von Strommeßwiderstand 4 und Source S des Feldeffekttransistors 11 geführt ist. Außerdem ist anstelle der nach Figur 1 vorgesehenen Z-Diode 7 eine Anordnung zur Spannungsbegrenzung vorgesehen, bei der der Kondensator 8 mit seinem am Ausgang A des RC-Gliedes liegenden Anschluß über die in Durchlaßrichtung gepolte Diode 16 an den Ausgang einer Anordnung zur Spannungsstabilisierung geführt ist. Als Anordnung zur Spannungsstabilisierung dient die an die Versorgungsspannungsquelle 1 angeschlossene Serienschaltung aus dem Widerstand 14 und der für die Versorgungsspannung in Sperrichtung gepolten Z-Diode 15. Dabei sind die Anoden der Z-Diode 15 und der Diode 16 miteinander verbunden. Die Kathode der Z-Diode 15 liegt am Minuspol der Versorgungsspannungsquelle 1. Abweichend von Fig. 2 kann die Z-Diode 15 anstatt an Minuspol an der Source S des Feldeffekttransistors 11 angeschlossen sein.

Außerdem ist parallel zur Drain-Source-Strecke des Feldeffekttransistors 11 als Entlastungswiderstand der Widerstand 20 angeordnet. Dieser Widerstand 20 dient zur Verringerung der Impulsbelastung des MOS-FET 11. Dadurch wird nicht bei einem Strom 0 sondern mit einem durch die Eingangsspannung und die Größe des Widerstandes 20 festgelegten Strom eingeschaltet. Der Sollwert- bzw. Referenzspannungsgeber 3 und der Verstärker 5 nach Figur 1 sind durch einen einzigen Transistor 17 realisiert. Die Schwellspannung an seiner Basis-Emitterstrecke bildet den Sollwert. Der Widerstand 18 ist als Basis-Schutzwiderstand vorgesehen. Die Entkopplungsdiode 6 nach Figur 1 ist nicht erforderlich.

Die aus den Schaltmitteln 14, 15, 16 bestehende Begrenzungsschaltung zur Begrenzung der Gatespannung ist insbesondere für vergleichsweise lange Verzögerungszeiten, also einen sehr hochohmigen Ladewiderstand 9, vorgesehen. Aus diesem Grunde ist eine getrennte Einspeisung der Z-Diode 15 über den Widerstand 14 vorgesehen. Die Begrenzung der Spannung am Ladekondensator 8 erfolgt mit Hilfe der Überlaufdiode 16.

Zum Spannungsschutz des MOS-FET 11 ist die Z-Diode 19 entsprechender Spannung über den negativen Zweig der Schutzschaltung gelegt. Diese Z-Diode 19 dient gleichzeitig als Schutz bei inversen Strömen.

Die in Figur 3 gezeigte Schaltungsanordnung stimmt mit der nach Figur 2 weitgehend überein. Abweichend von Figur 2 wird der Speicherkondensator 12 zusätzlich als Bestandteil des Verzögerungsgliedes ausgenutzt. Parallel zum Speicherkondensator 12 liegt der aus dem Widerstand 23, der Z-Diode 24 und dem Widerstand 25 bestehende Spannungsteiler. Die Z-Diode 24 ist zwischen den beiden Widerständen 23 und 25 angeordnet und für die am Speicherkondensator 12 auftretende Ladespannung in Sperrichtung gepolt. Der Transistor 22 ist mit seinem Emitter an den Pluspol der Versorgungsspannungsquelle 1 und mit seiner Basis an den Verbindungspunkt von Widerstand 23 und Z-Diode 24 angeschlossen. Zwischen Gate G und Source S des Feldeffekttransistors 11 liegt der Widerstand 33.

Der Kollektor des Transistors 22 bildet den Ausgang der Verzögerungsschaltung und ist als solcher über den Widerstand 10 an das Gate G des Feldeffekttransistors 11 geführt. Außerdem ist parallel zur Emitterkollektorstrecke des Transistors 17 die Z-Diode 21 angeordnet, wobei die Anode der Z-Diode 21 mit dem Emitter des Transistors 17 verbunden ist.

In Verbindung mit dem Widerstand 20 dient statt des Ladekondensators 8 nach Figur 2 der Speicherkondensator 12 selbst als Kondensator des Verzögerungsgliedes. Mit Hilfe des Spannungsteilers 23...25 wird die Spannung am Ausgang der Schutzschaltung erfaßt. Beim Überschreiten eines vorgegebenen Wertes wird das Gate G über den Widerstand 10 und den bipolaren Transistor 22 an die positive Eingangsspannung gelegt. Zur Begrenzung der Gatespannung dient die Z-Diode 21.

Das Verhalten der Schaltungsanordnung bei Überspannungsimpulsen stimmt mit dem nach den Figuren 1 und 2 überein.

Figur 4 zeigt für die in den Figuren 1 - 3 gezeigten Schaltungsanordnungen eine Vorrichtung zur selbsttätigen Freigabe der Stromversorgungsanordnung 13. Die elektrische Freigabe der Stromversorgungsanordnung 13 bzw. der eigentlichen Umrichterschaltung des Stromversorgungsgerätes erfolgt erst dann, wenn der Speicherkondensator 12 nahezu vollständig auf den jeweiligen Wert der Versorgungsspannung aufgeladen ist. Als Kriterium für diesen Zustand dient die Spannung, die an der Drain-Source-Strecke des Feldeffektransistors 11 abfällt.

Die Stromversorgungsanordnung 13 enthält z.B. als integrierte Steuerschaltung den Steuerbaustein 32 vom Typ TDA4718. Dieser Steuerbaustein 32 ist Bestandteil eines taktgesteuerten Umrichters oder dergleichen üblicher Art, der deshalb in der Figur nicht näher dargestellt ist.

Von den Anschlüssen des Steuerbausteins 32 sind nur die Anschlüsse a1, a6 und a7 bezeichnet. Die Zahl dieser Bezeichnungen stimmt jeweils mit der Anschlußnummer des integrierten Bausteins TDA4718 überein. Der Anschluß a6 dient zur Abschaltung bei Unterspannung, der Anschluß a7 zur Abschaltung bei Überspannung. Die Abschaltung bewirkt jeweils, daß die Stromversorgungsanordnung 13 keine Leistung aufnimmt.

Der Anschluß a1 für Bezugspotential bzw. 0 V ist mit dem Minuspol des Kondensators 12 verbunden. Zwischen dem positiven Anschluß des Speicherkondensators 12 und dem Anschluß a1 des Steuerbausteins 32 liegt der aus den Widerständen 29, 30 und 31 bestehende Spannungsteiler. Bei diesem Spannungsteiler liegt der Widerstand 29 zwischen dem Speicherkondensator 12 und dem Anschluß a6, der Widerstand 30 zwischen den Anschlüssen a6 und a7 und der Widerstand 31 zwischen den Anschlüssen a7 und a1.

Wird der zunächst noch entladene Speicherkondensator 12 aufgeladen, so bewegt sich die entsprechend dem Teilerverhältnis des Spannungsteilers geteilte Spannung am Anschluß a6 zunächst im Bereich der Unterspannungsabschaltung, so daß die Steuerung bzw. Regelung stillgesetzt ist. Der Spannungsteiler ist so bemessen, daß bei nicht leitendem Transistorteil des Optokopplers 28 die dem Anschluß a6 zugeführte Spannung den Bereich der Unterspannungsabschaltung verläßt, sobald der Speicherkondensator 12 auf einen vorgegebenen Wert der Spannung aufgeladen ist. Bei Überschreiten eines vorgegebenen oberen Grenzwertes der Kondensatorspannung tritt die am Anschluß a7 auftretende Spannung in den Bereich der Überspannungsabschaltung ein.

Der Optokoppler 28 liegt mit der Emitterkollektorstrecke seines Transistorteils zwischen den Anschlüssen a6 und a1. Im leitenden Zustand des Transistorteils verschwindet die Spannung am Anschluß a6, so daß die Abschaltung des Steuerbausteins bei Unterspannung wirksam wird. Dieser Fall tritt dann ein, wenn die Drain-Source-Spannung am MOS-FET11 einen im wesentlichen durch die Zenerspannung der Z-Diode 27 vorgegebenen Wert überschreitet.

Der Drainanschluß D des Feldeffekttransistors 11 ist über eine Serienschaltung, bestehend aus dem Widerstand 26, der Z-Diode 27 und dem Diodenteil des Optokopplers 28 an die Source S geführt. Die Z-Diode 27 und die Diode des Optokopplers 28 sind so gepolt, daß die Z-Diode und der Diodenteil mit einander entgegengesetzter Polarität in Serie geschaltet sind und daß der Diodenteil, bezogen auf den Ladestrom des Speicherkondensators 12, in Durchlaßrichtung gepolt ist.

Der Transistorteil des Optokopplers 28 bildet einen elektronischen Schalter, der durch die Drain-Source-Spannung des MOS-FETs 11 steuerbar ist.

Mit Hilfe der in Figur 4 gezeigten Anordnung wird erreicht, daß die getaktete Stromversorgungsanordnung 13 erst dann freigegeben wird, wenn die Spannung an der Drain-Source-Strecke des MOS-FETs 11 einen vorgegebenen Wert unterschreitet, d.h. sobald der Speicherkondensator 12 weitgehend mit der Spannung der Speisespannungsquelle 1 übereinstimmt. Hierdurch ergibt sich der Vorteil, daß das Stellglied während des Starts wegen der kürzeren Ladezeit geringer belastet ist.

Als Schaltung zur Begrenzung der Gate-Spannung des MOS-FETs dient nach Figur 1 eine Z-Diode 7, nach Figur 2 die Diode 14, 15, 16 und nach Figur 3 die Z-Diode 21. Anstelle dieser, in den genannten Schaltungsanordnungen austauschbaren Vorrichtungen können gegebenenfalls andere geeignete Spannungsbegrenzer Verwendung finden.

## Patentansprüche (Patentansprüche für folgende(n) Vertragsstaat(en): AT, BE, CH, ES, FR, GB, GR, IT, LI, LU, NL, SE)

1. Schaltungsanordnung zur Verringerung des Einschaltstromes durch Verzögerung wenigstens eines Teiles des Einschaltstromes bei getakteten Stromversorgungsgeräten mit einem Speicherkondensator (12), der eine niederohmige Spannungsquelle für eine daran angeschlossene Stromversorgungsanordnung (13) bildet, wobei zur Verzögerung des in den Speicherkondensator (12) fließenden Ladestromes zwischen der Speisespannungsquelle (1) und dem Speicherkondensator (12) die Source-Drain-Strecke eines Feldeffekttransistors (11) angeordnet und das Gate (G) des Feldeffekttransistors (11) an den Ausgang (A) eines Verzögerungsgliedes (8, 9 bzw. 4, 20, 12, 23, 24, 25, 22) angeschlossen ist, das bei Verbinden des entladenen Speicherkondensators (12) mit der Speisespannungsquelle (1) nach Ablauf einer vorgegebenen Verzögerungszeit an seinem Ausgang (A) ein den Feldeffekttransistor leitend steuerndes Potential (+) abgibt,
**dadurch gekennzeichnet,** daß zur Einschaltstrombegrenzung und zur Begrenzung der am Speicherkondensator (12) auftretenden Ladespannung (U12) bei Eingangsspannungsimpulsen eine Anordnung zur Strombegrenzung vorgesehen ist, die einen in Serie zur Source-Drain-Strecke des Feldeffekttransistors (11) angeordneten Strommeßwiderstand (4) und eine an den Strommeßwiderstand (4) angeschlossene und einen Strombegrenzer bildende Verstärkeranordnung (5, 6; 17) enthält, die bei am Strommeßwiderstand (4) abfallenden Spannungen unterhalb einer vorgegebenen Spannung an ihrem Ausgang hochohmig an das Gate des Feldeffekttransistors (11) angeschlossen ist und bei am Strommeßwiderstand (4) abfallenden Spannungen oberhalb der vorgegebenen Spannung ein den Feldeffekttransistor im Sinne einer Strombegrenzung steuerndes Potential abgibt, und daß der Ausgang (A) des Verzögerungsgliedes (8, 9 bzw. 4, 20, 12, 23, 24, 25, 22) über einen Entkopplungswiderstand (10) und der Ausgang der Verstärkereinrichtung (5, 6; 17) im Sinne einer ODER-Schaltung an das Gate (G) des Feldeffekttransistors geführt sind.

2. Schaltungsanordnung nach Anspruch 1,
**dadurch gekennzeichnet,** daß der Strommeßwiderstand (4) zwischen der Speisespannungsquelle (1) und der Source (S) des Feldeffekttransistors (11) angeordnet ist, und daß der Verstärker mit seinem invertierenden Eingang (-) an den Verbindungspunkt von Strommeßwiderstand (4) und Source angeschlossen ist und daß der Verstärker durch einen Differenzverstärker (5) mit offenem Kollektorausgang oder mit nachgeschalteter Entkopplungsdiode (6) gebildet ist und daß der nicht invertierende Eingang (+) des Differenzverstärkers (5) an den Ausgang eines Referenzspannungsgebers (3) angeschlossen ist.

3. Schaltungsanordnung nach Anspruch 1,
**dadurch gekennzeichnet,** daß der Verstärker durch einen bipolaren Transistor (17) gebildet ist, dessen Emitter-Basis-Strecke als Referenzspannungsgeber dient und dessen Emitter an das eine Ende des Strommeßwiderstandes und an die Speisespannungsquelle (1), dessen Kollektor an das Gate (G) des Feldeffekttransistors (11) und dessen Basis über einen Widerstand (18) an den Verbindungspunkt von Strommeßwiderstand (4) und Source (S) des Feldeffekttransistors (11) geführt ist und daß der Strommeßwiderstand (4) mit seinem anderen Ende mit dem Emitter des Transistors (17) und der Speisespannungsquelle (1) verbunden ist.

4. Schaltungsanordnung nach einem der Ansprüche 1 bis 3,
**dadurch gekennzeichnet,** daß das Verzögerungsglied durch ein RC-Glied gebildet ist, das aus einem Kondensator (8) und einem dazu in Serie angeordneten Widerstand (9) besteht und das parallel zu der aus Speisespannungsquelle (1) und Strommeßwiderstand (4) bestehenden Serienschaltung liegt und dessen Kondensator (8) mit der Source (S) des Feldeffekttransistors (11) verbunden ist.

5. Schaltungsanordnung nach einem der Ansprüche 1 bis 4,
**dadurch gekennzeichnet,** daß parallel zur Source-Drain-Strecke des Feldeffekttransistors (11) ein Widerstand (20) liegt.

6. Schaltungsanordnung nach Anspruch 5,
**dadurch gekennzeichnet,**
daß die Verzögerungsschaltung durch den Speicherkondensator (12) und die in seinem Ladestromkreis liegenden Schaltmittel (4,20) und durch einen durch die Spannung des Speicherkondensators (12) steuerbaren, an ein den Feldeffekttransistor (11) leitend steuerndes Potential (+) angeschlossenen elektronischen Schalter (22,23,24,25) gebildet ist.

7. Schaltungsanordnung nach Anspruch 6,
**dadurch gekennzeichnet,**
daß der elektronische Schalter durch einen bipolaren Transistor (22) gebildet ist, dessen Basis mit dem Abgriff eines parallel zum Speicherkondensator (12) liegenden Spannungsteilers (23,24,25) und dessen Emitter mit der Speisespannungsquelle (1) verbunden ist und dessen Kollektor den Ausgang (A) der Verzögerungsschaltung bildet.

8. Schaltungsanordnung nach Anspruch 7,
**dadurch gekennzeichnet,**
daß der Spannungsteiler zwischen Basis und Emitter des Transistors (22) einen Widerstand (23) und im anderen Zweig eine Serienschaltung aus einer Z-Diode (24) und einem Widerstand (25) enthält.

9. Schaltungsanordnung nach einem der Ansprüche 1 bis 8,
**dadurch gekennzeichnet,**
daß parallel zu der aus dem Strommeßwiderstand (4) und der Source-Drain-Strecke des Feldeffekttransistors (11) bestehenden Serienschaltung eine für den Ladestrom des Speicherkondensators (12) in Sperrichtung gepolte Diode oder Z-Diode (19) angeordnet ist.

10. Schaltungsanordnung nach einem der vorhergehenden Ansprüche,
**dadurch gekennzeichnet,**
daß die Stromversorgungsanordnung (13) eine durch die Spannung des Speicherkondensators (12) steuerbare Vorrichtung zur Ausschaltung der Stromversorgungsanordnung (13) bei eingangsseitiger Unterspannung enthält und daß die Vorrichtung zur Ausschaltung der Stromversorgungsanordnung zusätzlich durch die Drain-Source-Spannung (U_{DS}) des Feldeffekttransistors (11) derart steuerbar ist, daß die Stromversorgungsanordnung (13) bei oberhalb eines vorgegebenen Grenzwertes liegenden Drain-Source-Spannungen (U_{DS}) ausgeschaltet ist.

## Patentansprüche (Patentansprüche für folgende(n) Vertragsstaat(en): DE)

1. Schaltungsanordnung zur Verringerung des Einschaltstromes durch Verzögerung wenigstens eines Teiles des Einschaltstromes bei getakteten Stromversorgungsgeräten mit einem Speicherkondensator (12), der eine niederohmige Spannungsquelle für eine daran angeschlossene Stromversorgungsanordnung (13) bildet, wobei zur Verzögerung des in den Speicherkondensator (12) fließenden Ladestromes zwischen der Speisespannungsquelle (1) und dem Speicherkondensator (12) die Source-Drain-Strecke eines Feldeffekttransistors (11) angeordnet und das Gate (G) des Feldeffekttransistors (11) an den Ausgang (A) eines Verzögerungsgliedes (4, 20, 12, 23, 24, 25, 22) angeschlossen ist, das bei Verbinden des entladenen Speicherkondensators (12) mit der Speisespannungsquelle (1) nach Ablauf einer vorgegebenen Verzögerungszeit an seinem Ausgang (A) ein den Feldeffekttransistor leitend steuerndes Potential (+) abgibt, wobei parallel zur Source-Drain-Strecke des Feldeffekttransistors (11) ein Widerstand (20) liegt, wobei zur Einschaltstrombegrenzung und zur Begrenzung der am Speicherkondensator (12) auftretenden Ladespannung (U12) bei Eingangsspannungsimpulsen eine Anordnung zur Strombegrenzung vorgesehen ist, die einen in Serie zur Source-Drain-Strecke des Feldeffekttransistors (11) angeordneten Strommeßwiderstand (4) und eine an den Strommeßwiderstand (4) angeschlossene und einen Strombegrenzer bildende Verstärkeranordnung (5, 6; 17) enthält, die bei am Strommeßwiderstand (4) abfallenden Spannungen unterhalb einer vorgegebenen Spannung an ihrem Ausgang hochohmig an das Gate des Feldeffekttransistors (11) angeschlossen ist und bei am Strommeßwiderstand (4) abfallenden Spannungen oberhalb der vorgegebenen Spannung ein den Feldeffekttransistor im Sinne einer Strombegrenzung steuerndes Potential abgibt, wobei der Ausgang (A) des Verzögerungsgliedes (4, 20, 12, 23, 24, 25, 22) über einen Entkopplungswiderstand (10) und der Ausgang der Verstärkeranordnung (5, 6; 17) im Sinne einer ODER-Schaltung an das Gate (G) des Feldeffekttransistors geführt sind, und wobei die Verzögerungsschaltung durch den Speicherkondensator (12) und die in seinem Ladestromkreis liegenden Schaltmittel (4,20) gebildet ist,
**dadurch gekennzeichnet,**
daß ein durch die Spannung des Speicherkondensators (12) steuerbarer und an ein den Feldeffekttransistor (11) leitend steuerndes Potential (+) angeschlossener elektronischer Schalter (22 ... 25) vorgesehen ist.

2. Schaltungsanordnung nach Anspruch 1,
**dadurch gekennzeichnet,**
daß der elektronische Schalter durch einen bipolaren Transistor (22) gebildet ist, dessen Basis mit dem Abgriff eines parallel zum Speicherkondensator (12) liegenden Spannungsteilers (23, 24, 25) und dessen Emitter mit der Speisespannungsquelle (1) verbunden ist und dessen Kollektor den Ausgang (A) der Verzögerungsschaltung bildet.

3. Schaltungsanordnung nach Anspruch 2,
**dadurch gekennzeichnet,**
daß der Spannungsteiler zwischen Basis und Emitter des Transistors (22) einen Widerstand (23) und im anderen Zweig eine Serienschaltung aus einer Z-Diode (24) und einem Widerstand (25) enthält.

4. Schaltungsanordnung nach einem der Ansprüche 1 bis 3,
**dadurch gekennzeichnet,**
daß parallel zu der aus dem Strommeßwiderstand (4) und der Source-Drain-Strecke des Feldeffekttransistors (11) bestehenden Serienschaltung eine für den Ladestrom des Speicherkondensators (12) in Sperrichtung gepolte Diode oder Z-Diode (19) angeordnet ist.

5. Schaltungsanordnung nach einem der Ansprüche 1 bis 4,
**dadurch gekennzeichnet,**
daß die Stromversorgungsanordnung (13) eine durch die Spannung des Speicherkondensators (12) steuerbare Vorrichtung zur Ausschaltung der Stromversorgungsanordnung (13) bei eingangsseitiger Unterspannung enthält und daß die Vorrichtung zur Ausschaltung der Stromversorgungsanordnung zusätzlich durch die Drain-Source-Spannung (U_{DS}) des Feldeffekttransistors (11) derart steuerbar ist, daß die Stromversorgungsanordnung (13) bei oberhalb eines vorgegebenen Grenzwertes liegenden Drain-Source-Spannungen (U_{DS}) ausgeschaltet ist.

6. Schaltungsanordnung nach einem der Ansprüche 1 bis 5,
**dadurch gekennzeichnet,**
daß der Strommeßwiderstand (4) zwischen der Speisespannungsquelle (1) und der Source (S) des Feldeffekttransistors (11) angeordnet ist, und daß der Verstärker mit seinem invertierenden Eingang (-) an den Verbindungspunkt von Strommeßwiderstand (4) und Source angeschlossen ist und daß der Verstärker durch einen Differenzverstärker (5) mit offenem Kollektorausgang oder mit nachgeschalteter Entkopplungsdiode (6) gebildet ist und daß der nicht invertierende Eingang (+) des Differenzverstärkers (5) an den Ausgang eines Referenzspannungsgebers (3) angeschlossen ist.

7. Schaltungsanordnung nach einem der Ansprüche 1 bis 5,
**dadurch gekennzeichnet,**
daß der Verstärker durch einen bipolaren Transistor (17) gebildet ist, dessen Emitter-Basis-Strecke als Referenzspannungsgeber dient und dessen Emitter an die Speisespannungsquelle (1), dessen Kollektor an das Gate (G) des Feldeffekttransistors (11) und dessen Basis über einen Widerstand (18) an den Verbindungspunkt von Strommeßwiderstand (4) und Source (S) des Feldeffekttransistors (11) geführt ist und daß der Strommeßwiderstand (4) mit seinem anderen Ende mit dem Emitter des Transistors (17) und der Speisespannungsquelle (1) verbunden ist.

## Claims (Claims for the following Contracting State(s): AT, BE, CH, ES, FR, GB, GR, IT, LI, LU, NL, SE)

1. Circuit arrangement for reducing the switching-on current, by delaying at least a part of the switching-on current, in the case of pulsed power-supply apparatuses having a storage capacitor (12) which forms a low-impedance voltage source for a power-supply arrangement (13) which is connected thereto, the source-drain junction of a field-effect transistor (11) being arranged between the supply-voltage source (1) and the storage capacitor (12) in order to delay the charging current flowing into the storage capacitor (12), and the gate (G) of the field-effect transistor (11) being connected to the output (A) of a delay element (8, 9 or 4, 20, 12, 23, 24, 25, 22 respectively) which, in the event of the discharged storage capacitor (12) being connected to the supply-voltage source (1) and after a predetermined delay time has elapsed, emits at its output (A) a potential (+) which switches the field-effect transistor on, characterised in that in order to limit the switching-on current and in order to limit the charging voltage (U12) occurring on the storage capacitor (12) in the event of input-voltage pulses, an arrangement for current limiting is provided, which contains a current-measurement resistor (4), which is arranged in series with the source-drain junction of the field-effect transistor (11), and an amplifier arrangement (5, 6; 17), which is connected to the current-measurement resistor (4) and forms a current limiter, which arrangement is connected at its output in a high impedance manner to the gate of the field-effect transistor (11) in the case of voltages which are dropped on the current-measurement resistor (4) being less than a predetermined voltage, and emits a potential which controls the field-effect transistor in the sense of current limiting in the event of voltages which are dropped on the current-measurement resistor (4) being above the predetermined voltage, and in that the output (A) of the delay element (8, 9 or 4, 20, 12, 23, 24, 25, 22 respectively) is connected to the gate (G) of the field-effect transistor via a decoupling resistor (10), and the output of the amplifier device (5, 6; 17) is connected to the gate (G) of the field-effect transistor, said connections being in the sense of an OR circuit.

2. Circuit arrangement according to Claim 1, characterised in that the current-measurement resistor (4) is arranged between the supply-voltage source (1) and the source (S) of the field-effect transistor (11), and in that the inverting input (-) of the amplifier is connected to the connecting point of the current-measurement resistor (4) and the source, and in that the amplifier is formed by a differential amplifier (5) with an open collector output or with a downstream-connected decoupling diode (6), and in that the non-inverting input (+) of the differential amplifier (5) is connected to the output of a reference-voltage transmitter (3).

3. Circuit arrangement according to Claim 1, characterised in that the amplifier is formed by a bipolar transistor (17) whose emitter-base junction is used as the reference-voltage transmitter and whose emitter is connected to the one end of the current-measurement resistor and to the supply-voltage source (1), whose collector is connected to the gate (G) of the field-effect transistor (11), and whose base is connected via a resistor (18) to the connection point of the current-measurement resistor (4) and the source (S) of the field-effect transistor (11), and in that the other end of the current-measurement resistor (4) is connected to the emitter of the transistor (17) and to the supply-voltage source (1).

4. Circuit arrangement according to one of Claims 1 to 3, characterised in that the delay element is formed by an RC element which comprises a capacitor (8) and a resistor (9), arranged in series therewith, and is connected in parallel with a series circuit, comprising the supply-voltage source (1) and the current-measurement resistor (4), and whose capacitor (8) is connected to the source (S) of the field-effect transistor (11).

5. Circuit arrangement according to one of Claims 1 to 4, characterised in that a resistor (20) is connected in parallel with the source-drain junction of the field-effect transistor (11).

6. Circuit arrangement according to Claim 5, characterised in that the delay circuit is formed by the storage capacitor (12) and the switching means (4, 20) located in its charging circuit, and by an electronic switch (22, 23, 24, 25) which can be controlled by the voltage of the storage capacitor (12) and is connected to a potential (+) which switches the field-effect transistor (11) on.

7. Circuit arrangement according to Claim 6, characterized in that the electronic switch is formed by a bipolar transistor (22) whose base is connected to the pick-off of a voltage divider (23, 24, 25), connected in parallel with the storage capacitor (12), and whose emitter is connected to the supply-voltage source (1), and whose collector forms the output (A) of the delay circuit.

8. Circuit arrangement according to Claim 7, characterized in that the voltage divider contains a resistor (23) between the base and emitter of the transistor (22), and contains a series circuit comprising a Zener diode (24) and a resistor (25), in the other branch.

9. Circuit arrangement according to one of Claims 1 to 8, characterized in that a diode or a Zener diode (19), whose polarity is in the reverse direction for the charging current of the storage capacitor (12), is arranged in parallel with the series circuit which comprises the current-measurement resistor (4) and the source-drain junction of the field-effect transistor (11).

10. Circuit arrangement according to one of the preceding claims, characterized in that the power-supply arrangement (13) contains a device, which can be controlled by the voltage of the storage capacitor (12), for switching off the power-supply arrangement (13) in the event of an undervoltage on the input side, and in that the device for switching off the power-supply arrangement can additionally be controlled by the drain-source voltage (U_{DS}) of the field-effect transistor (11) in such a manner that the power-supply arrangement (13) is switched off in the event of drain-source voltages (U_{DS}) which are above a predetermined limiting value.

## Claims (Claims for the following Contracting State(s): DE)

1. Circuit arrangement for reducing the switching-on current, by delaying at least a part of the switching-on current, in the case of pulsed power-supply apparatuses having a storage capacitor (12) which forms a low-impedance voltage source for a power-supply arrangement (13) which is connected thereto, the source-drain junction of a field-effect transistor (11) being arranged between the supply-voltage source (1) and the storage capacitor (12) in order to delay the charging current flowing into the storage capacitor (12), and the gate (G) of the field-effect transistor (11) being connected to the output (A) of a delay element (8, 9 or 4, 20, 12, 23, 24, 25, 22 respectively) which, in the event of the discharged storage capacitor (12) being connected to the supply-voltage source (1) and after a predetermined delay time has elapsed, emits at its output (A) a potential (+) which switches the the field-effect transistor on, wherein a resistor (20) is connected in parallel with the source-drain junction of the field-effect transistor (11), wherein in order to limit the switching-on current and in order to limit the charging voltage (U12) occuring on the storage capacitor (12) in the event of input-voltage pulses, an arrangement for current limiting is provided, which contains a current-measurement resistor (4), which is arranged in series with the source-drain junction of the field-effect transistor (11), and an amplifier arrangement (5, 6; 17), which is connected to the current-measurement resistor (4) and forms a current limiter, which arrangement is connected at its output in a high impedance manner to the gate of the field-effect transistor (11) in the case of voltages which are dropped on the current-measurement resintor (4) being less than a predetermined voltage, and emits a potential which controls the field-effect transistor in the sense of current limiting in the event of voltages which are dropped on the current-measurement resistor (4) being above the predetermined voltage, and in that the output (A) of the delay element (8, 9 or 4, 20, 12, 23, 24, 25, 22 respectively) is connected to the gate (G) of the field-effect transistor via a decoupling resistor (10), and the output of the amplifier device (5, 6; 17) is connected to the gate (G) of the field-effect transistor, said connections being in the sense of an OR circuit and wherein the delay circuit is formed by the storage capacitor (12) and the switching means (4, 20) located in its charging circuit,
**characterized**
by an electronic switch (22 ... 25) which can be controlled by the voltage of the storage capacitor (12) and is connected to a potential (+) which switches the field-effect transistor (11) on.

2. Circuit arrangement according to Claim 1, characterised in that the electronic switch is formed by a bipolar transistor (22) whose base is connected to the pick-off of a voltage divider (23, 24, 25), connected in parallel with the storage capacitor (12), and whose emitter is connected to the supply-voltage source (1), and whose collector forms the output (A) of the delay circuit.

3. Circuit arrangement according to Claim 2, characterised in that the voltage divider contains a resistor (23) between the base and emitter of the transistor (22), and contains a series circuit comprising a Zener diode (24) and a resistor (25), in the other branch.

4. Circuit arrangement according to one of Clams 1 to 3, characterised in that a diode or a Zener diode (19), whose polarity is in the reverse direction for the charging current of the storage capacitor (12), is arranged in parallel with the series circuit which comprises the current-measurement resistor (4) and the source-drain junction of the field-effect transistor (11).

5. Circuit arrangement according to one of claims 1 to 4, characterised in that the power-supply arrangement (13) contains a device, which can be controlled by the voltage of the storage capacitor (12), for switching off the power-supply arrangement (13) in the event of an undervoltage on the input side, and in that the device for switching off the power supply arrangement can additionally be controlled by the drain-source voltage (U_{DS}) of the field-effect transistor (11) in such a manner that the power-supply arrangement (13) is switched off in the event of drain-source voltages (U_{DS}) which are above a predetermined limiting value.

6. Circuit arrangement according to one of claims 1 to 5, characterised in that the current-measurement resistor (4) is arranged between the supply-voltage source (1) and the source (S) of the field-effect transistor (11), and in that the inverting input (-) of the amplifier is connected to the connecting point of the current-measurement resistor (4) and the source, and in that the amplifier is formed by a differential amplifier (5) with an open collector output or with a downstream-connected decoupling diode (6), and in that the non-inverting input (+) of the differential amplifier (5) is connected to the output of a reference-voltage transmitter (3).

7. Circuit arrangement according to one of claims 1 to 5, characterised in that the amplifier is formed by a bipolar transistor (17) whose emitter-base junction is used as the reference-voltage transmitter and whose emitter is connected to the one end of the current-measurement resistor and to the supply-voltage source (1), whose collector is connected to the gate (G) of the field-effect transistor (11), and whose base is connected via a resistor (18) to the connection point of the current-measurement resistor (4) and the source (S) of the field-effect transistor (11), and in that the other end of the current-measurement resistor (4) is connected to the emitter of the transistor (17) and to the supply-voltage source (1).

## Revendications (Revendications pour l'(les) Etat(s) contractant(s) suivant(s): AT, BE, CH, ES, FR, GB, GR, IT, LI, LU, NL, SE)

1. Montage pour réduire le courant de branchement en retardant au moins une partie du courant de branchement, pour des unités d'alimentation cadencées comportant un condensateur à accumulation d'énergie (12) qui constitue une source de tension faiblement ohmique pour un dispositif d'alimentation en courant (13) qui lui est relié, du type dans lequel, pour obtenir le retard du courant de charge dans le condensateur à accumulation d'énergie (12), la section source-drain d'un transistor à effet de champ (11) est disposée entre la source de tension d'alimentation (1) et le condensateur à accumulation d'énergie (12), la grille (G) du transistor à effet de champ (11) étant reliée à la sortie (A) d'un circuit à retard (8, 9 ou 4, 20, 12, 23, 24, 25, 22) qui fournit à sa sortie, lors de la liaison du condensateur à accumulation d'énergie (12) déchargé avec la source de tension d'alimentation (1), et après l'écoulement d'un retard prédéterminé, un potentiel (+) qui commande le transistor à effet de champ à l'état passant,
caractérisé en ce que, pour limiter le courant de branchement et pour limiter la tension de charge (U12) au niveau du condensateur à accumulation d'énergie (12), il est prévu, lors des impulsions de tensions d'entrée, un dispositif pour limiter le courant qui comporte une résistance de mesure du courant (4) montée en série avec la section source-drain du transistor à effet de champ (11) et un dispositif amplificateur (5, 6 ; 17) relié à la résistance de mesure du courant (4) et formant un limitateur de courant, dispositif amplificateur qui, pour des chutes de tension au niveau de la résistance de mesure du courant (4) en-dessous d'une tension prédéterminée est relié, à sa sortie, avec une forte valeur ohmique à la grille du transistor à effet de champ (11), et qui, pour des chutes de tension au niveau de la résistance de mesure du courant (4) au-dessus de la tension prédéterminée, fournit un potentiel qui commande le transistor à effet de champ, dans le sens d'une limitation du courant, et que la sortie (A) du circuit à retard (8, 9 ou 4, 20, 12, 23, 24, 25, 22) est reliée, par l'intermédiaire d'une résistance de découplage (10), à la grille (G) du transistor à effet de champ et la sortie du dispositif amplificateur (5, 6 ; 17) est reliée à la grille (G) du transistor à effet de champ, dans le sens d'un circuit porte OU.

2. Montage suivant la revendication 1,
caractérisé en ce que la résistance de mesure du courant (4) est montée entre la source de tension d'alimentation (1) et la source (S) du transistor à effet de champ (11), que l'entrée inverseuse (-) de l'amplificateur est reliée au point de liaison de la résistance de mesure du courant (4) avec la source, que l'amplificateur est constitué d'un amplificateur différentiel (5) à sortie à collecteur ouvert ou à diode de découplage (6) aval, et que l'entrée (+) non inverseuse de l'amplificateur différentiel (5) est reliée à la sortie d'un générateur de tension de référence (3).

3. Montage suivant la revendication 1,
caractérisé en ce que l'amplificateur est constitué d'un transistor bipolaire (17) dont la section émetteur-base sert de générateur de tension de référence, dont l'émetteur est relié à l'une des extrémités de la résistance de mesure du courant et à la source de tension d'alimentation (1), dont le collecteur est relié à la grille (G) du transistor à effet de champ (11) et dont la base est reliée, par l'intermédiaire d'une résistance (18), au point de liaison de la résistance de mesure du courant (4) avec la source (S) du transistor à effet de champ (11), et que la résistance de mesure du courant (4) est reliée, par son autre extrémité, à l'émetteur du transistor (17) et à la source de tension d'alimentation (1).

4. Montage suivant l'une des revendication 1 à 3,
caractérisé en ce que le circuit à retard est formé d'un circuit RC qui est constitué d'un condensateur (8) et d'une résistance (9) montée en série avec ce dernier, et est branché en parallèle au circuit série constitué de la source de tension d'alimentation (1) et de la résistance de mesure du courant (4), et son condensateur (8) est relié à la source (S) du transistor à effet de champ (11).

5. Montage suivant l'une des revendications 1 à 4,
caractérisé en ce qu'une résistance (20) est montée en parallèle sur la section source-drain du transistor à effet de champ (11).

6. Montage suivant la revendication 5,
caractérisé en ce que le circuit à retard est formé du condensateur à accumulation d'énergie (12), ainsi que des moyens de commutation (4, 20) situés dans son circuit de charge, et d'un commutateur électronique (22, 23, 24, 25) susceptible d'être commandé par la tension du condensateur à accumulation d'énergie (12) et relié à un potentiel (+) qui commande le transistor à effet de champ (11) à l'état passant.

7. Montage suivant la revendication 6,
caractérisé en ce que le commutateur électronique est formé d'un transistor bipolaire (22) dont la base est reliée à la prise d'un diviseur de tension (23, 24, 25) branché en parallèle avec le condensateur à accumulation d'énergie (12), dont l'émetteur est relié à la source de tension d'alimentation (1), et dont le collecteur constitue la sortie (A) du circuit à retard.

8. Montage suivant la revendication 7,
caractérisé en ce que le diviseur de tension comporte une résistance (23) entre la base et l'émetteur du transistor (22), et dans l'autre branche, un circuit série constitué d'une diode Zener (24) et d'une résistance (25).

9. Montage suivant l'une des revendications 1 à 8,
caractérisé en ce que, en parallèle sur le circuit série constitué de la résistance de mesure du courant (4) et de la section source-drain du transistor à effet de champ (11), est montée une diode polarisée en inverse pour le courant de charge du condensateur à accumulation d'énergie (12) ou une diode Zener (19).

10. Montage suivant l'une des revendications précédentes,
caractérisé en ce que le dispositif d'alimentation en courant (13) comporte un dispositif qui peut-être commandé par la tension du condensateur à accumulation d'énergie (12) et qui est destiné à la mise hors-circuit du dispositif d'alimentation en courant (13) pour des sous-tensions côté entrée, et que le dispositif de mise hors-circuit du dispositif d'alimentation en courant peut être, en plus, commandé par la tension drain-source (U_{DS}) du transistor à effet de champs (11) de telle façon que le dispositif d'alimentation en courant (13) est mis hors-circuit pour des tensions drain-source (U_{DS}) situées au-dessus d'une valeur limite prédéterminée.

## Revendications (Revendications pour l'(les) Etat(s) contractant(s) suivant(s): DE)

1. Montage pour réduire le courant de branchement en retardant au moins une partie du courant de branchement, pour des unités d'alimentation cadencées comportant un condensateur à accumulation d'énergie (12) qui constitue une source de tension faiblement ohmique pour un dispositif d'alimentation on courant (13) qui lui est relié, du type dans lequel, pour obtenir le retard du courant de charge dans le condensateur à accumulation d'énergie (12), la section source-drain d'un transistor à effet de champ (11) est disposée entre la source de tension d'alimentation (1) et le condensateur à accumulation d'énergie (12), la grille (G) du transistor à effet de champ (11) étant reliée à la sortie (A) d'un circuit à retard (8, 9 ou 4, 20, 12, 23, 24, 25, 22) qui fournit à sa sortie, lors de la liaison du condensateur à accumulation d'énergie (12) déchargé avec la source de tension d'alimentation (1), et après l'écoulement d'un retard prédéterminé, un potentiel (+) qui commande le transistor à effet de champ à l'état passant, une résistance (20) étant montée en parallèle sur la section source-drain du transistor à effet de champ (11), dans lequel, pour limiter le courant de branchement et pour limiter la tension de charge (U12) au niveau du condensateur à accumulation d'énergie (12), il est prévu, lors des impulsions de tensions d'entrée, un dispositif pour limiter la courant qui comporte une résistance de mesure du courant (4) montée en série avec la section source-drain du transistor à effet de champ (11) et un dispositif amplificateur (5, 6 ; 17) relié à la résistance de mesure du courant (4) et formant un limitateur de courant, dispositif amplificateur qui, pour des chutes de tension au niveau de la résistance de mesure du courant (4) en-dessous d'une tension prédéterminée est relié, à sa sortie, avec une forte valeur ohmique à la grille du transistor à effet de champ (11), et qui, pour des chutes de tension au niveau de la résistance de mesure du courant (4) au-dessus de la tension prédéterminée, fournit un potentiel qui commande le transistor à effet de champ, dans le sens d'une limitation du courant, et que la sortie (A) du circuit à retard (8, 9 ou 4, 20, 12, 23, 24, 25, 22) est reliée, par l'intermédiaire d'une résistance de découplage (10), à la grille (G) du transistor à effet de champ et la sortie du dispositif amplificateur (5, 6 ; 17) est reliée à la grille (G) du transistor à effet de champ, dans le sens d'un circuit porte OU, et le circuit de retard étant formé du condensateur à accumulation d'énergie (12), ainsi que des moyens de commutation (24, 20) situées dans son circuit charge,
caracterisé en ce que un commutateur électronique (22 ... 25) è prévu étant susceptible d'être commandé par la tension du condensateur à accumulation d'énergie (12) et étant rélié à un potentiel (+) qui commande le transistor à effet de champ (11) à l'état passant.

2. Montage suivant la revendication 1,
caractérisé en ce que le commutateur électronique est formé d'un transistor bipolaire (22) dont la base est reliée à la prise d'un diviseur de tension (23, 24, 25) branché en parallèle avec le condensateur à accumulation d'énergie (12), dont l'émetteur est relié à la source de tension d'alimentation (1), et dont le collecteur constitue la sortie (A) du circuit à retard.

3. Montage suivant la revendication 2,
caractérisé en ce que le diviseur de tension comporte une résistance (23) entre la base et l'émetteur du transistor (22), et dans l'autre branche, un circuit série constitue d'une diode Zener (24) et d'une résistance (25).

4. Montage suivant l'une des revendication 1 à 3,
caractérisé en ce que, en parallèle sur le circuit série constitué de la résistance de mesure du courant (4) et de la section source-drain du transistor à effet de champ (11), est montée une diode polarisée en inverse pour le courant de charge du condensateur à accumulation d'énergie (12) ou une diode Zener (19).

5. Montage suivant l'une des revendications 1 a 4,
caractérisé en ce que le dispositif d'alimentation en courant (13) comporte un dispositif qui peut-être commandé par la tension du condensateur à accumulation d'énergie (12) et qui est destiné à la mise hors-circuit du dispositif d'alimentation en courant (13) pour des sous-tensions côté entrée, et que le dispositif de mise hors-circuit du dispositif d'alimentation en courant peut être, en plus, commandé par la tension drain-source (U_{DS}) du transistor à effet de champs (11) de telle façon que le dispositif d'alimentation en courant (13) est mis hors-circuit pour des tensions drain-source (U_{DS}) situées au-dessus d'une valeur limite prédéterminée.

6. Montage suivant l'une des revendications 1 à 5,
caractérisé en ce que la résistance de mesure du courant (4) est montée entre la source de tension d'alimentation (1) et la source (S) du transistor à effet de champ (11), que l'entrée inverseuse (-) de l'amplificateur est reliée au point de liaison de la résistance de mesure du courant (4) avec la source, que l'amplificateur est constitué d'un amplificateur différentiel (5) à sortie à collecteur ouvert ou à diode de découplage (6) aval, et que l'entrée (+) non inverseuse de l'amplificateur différentiel (5) est reliée à la sortie d'un générateur de tension de référence (3).

7. Montage suivant l'une des revendication 1 à 5,
caractérisé en ce que l'amplificateur est constitué d'un transistor bipolaire (17) dont la section émetteur-base sert de générateur de tension de référence, dont l'émetteur est relié à l'une des extrémités de la résistance de mesure du courant et à la source de tension d'alimentation (1), dont le collecteur est relié à la grille (G) du transistor à effet de champ (11) et dont la base est reliée, par l'intermédiaire d'une résistance (18), au point de liaison de la résistance de mesure du courant (4) avec la source (S) du transistor à effet de champ (11), et que la résistance de mesure du courant (4) est reliée, par son autre extrémité, à l'émetteur du transistor (17) et à la source de tension d'alimentation (1).
